# EUROPÄISCHE PATENTSCHRIFT

(11) **EP 1 472 765 B1**
(45) Veröffentlichungstag und Bekanntmachung des Hinweises auf die Patenterteilung: **28.03.2007**
(21) Anmeldenummer: 03720122.5
(22) Anmeldetag: 31.01.2003
(51) Int. Cl.: H01S 3/082

(54) **Lasergainmodul**
Laser gain module
Module de gain laser

(30) Priorität: 01.02.2002 DE 10204796
(43) Veröffentlichungstag der Anmeldung: 03.11.2004
(73) Patentinhaber: Smart Laser Systems GmbH, 14806 Hagelberg (DE)
(72) Erfinder: ERHARD, Jürgen, 12435 Berlin (DE); OZYGUS, Bernd, 10717 Berlin (DE)
(74) Vertreter: Schneider, Henry
(86) Internationale Anmeldenummer: PCT/DE2003/000326
(87) Internationale Veröffentlichungsnummer: WO 2003/065521

(56) Entgegenhaltungen:
- EP-A- 0 949 730
- DE-A- 4 229 498
- DE-U- 29 816 107
- US-A- 6 016 324
- MACDONALD M P ET AL: "Efficient polarised output from end-pumped multirod resonators" OPTICS COMMUNICATIONS, NORTH-HOLLAND PUBLISHING CO. AMSTERDAM, NL, Bd. 160, Nr. 4-6, 15. Februar 1999 (1999-02-15), Seiten 354-363, XP004158001 ISSN: 0030-4018
- TROBS M ET AL: "Efficient polarised output from a unidirectional multi-rod Nd:YVO4 ring resonator" OPTICS COMMUNICATIONS, NORTH-HOLLAND PUBLISHING CO. AMSTERDAM, NL, Bd. 182, Nr. 4-6, 15. August 2000 (2000-08-15), Seiten 437-442, XP004215636 ISSN: 0030-4018

## Beschreibung

Das Lasergainmodul ist beispielsweise anwendbar in den Bereichen der Markierungs- und Beschriftungstechnik, in der Medizintechnik sowie in weiteren Bereichen.

Es ist bekannt, dass diodengepumpte Festkörperlaser seit einigen Jahren die blitzlampengepumpten Systeme im Bereich kleinerer Leistungen verdrängen. Innerhalb der diodengepumpten Laser haben weiterhin die longitudinal gepumpten Laser gegenüber transversal gepumpten Systemen den Vorteil eines wesentlich höheren Wirkungsgrades bei gleichzeitig besserer Strahlqualität. Ein Nachteil des Endpumpens ist allerdings die zur Zeit auf 10 bis 15 Watt begrenzte Ausgangsleistung. Es gibt verschiedene Ansätze, diese Grenze zu höheren Leistungen hin zu verschieben. Ein Ansatz hierzu ist z.B. der sogenannte tightly folded resonator (EP 0 401 054 A2). Bei diesem Aufbau wird der Laserstrahl sehr eng gefaltet, so dass er der stark astigmatischen Pumpstrahlung einer Laserdiode angepaßt ist. Dieser Resonatortyp ist allerdings sehr justierempfindlich und hat sich in der Praxis nicht bewährt. Ein weiterer Ansatz sind z.B. die Multipath Lasersysteme (WO 96/17418). Hiermit ist es möglich, mit einem einfachen mechanischen Aufbau mehrere thermisch getrennte gepumpte Bereiche in einem größeren Laserkristall zu benutzen. Ein Nachteil dieser Anordnung ist die gegenseitigen Abhängigkeit von Resonatorlänge und Krümmungsradius des Auskoppelspiegels. Mit diesen Lasersystemen ist es nur begrenzt möglich, gute Strahlqualitäten bei gleichzeitig hohen Ausgangsleistungen zu erzeugen. DE 42 29 498 A offenbart einen laseraktiven Festkörper mit mehreren endgepumpten räumlich voneinander getrennten emittierenden Bereichen, bei denen über einen teilweise reflektierenden Spiegel eine gegenseitige Phasenkopplung aller Emitter untereinander stattfindet.

Die vorliegende Erfindung ermöglicht bei einem mechanisch einfachen Aufbau das gleichzeitige Pumpen mehrerer Stellen innerhalb aktiver Medien bei Umgehung der - bei den Multipath Systemen - vorhandenen Beschränkungen. Die Verbesserung wird dadurch erreicht, dass mit einem Strahlmanipulationselement mit Strahlteilereigenschaften mehrere Strahlengänge miteinander verbunden werden, in denen durch gezieltes Endpumpen eine Verstärkung der Laserstrahlung stattfindet, wobei die Strahlteilereigenschaft - je nach Aufbautyp - durch einen teilreflektierenden oder wellenlängenselektiven Spiegel, durch einen Polarisator, ein diffraktives Element oder anders gegeben ist. Hierbei entstehen im allgemeinen Systeme gekoppelter Resonatoren. In speziellen Fällen werden aber auch die einzelnen Verstärkungen im aktiven Medium nacheinander durchlaufen. Gegenüber dem Multipath Resonatorkonzept hat die vorliegende Erfindung den Vorteil der freien Resonatorwahl und den Vorteil der durch den - im allgemeinen - koaxialen Verlauf von Pumpstrahl und Laserstrahl besseren Pumpeffektivität.

Der wesentliche physikalische Unterschied des hier beschriebenen Aufbaus ist die Benutzung verbundener Strahlengänge. Die bisher bekannten Systeme beruhen alle auf Mehrfachreflexionen, bei denen die Reflexionsstellen im aktiven Medium gepumpt werden. Bei diesen bekannten Systemen sind die Laserstrahlen zu den Pumpstrahlen nicht koaxial, was zu einem schlechteren Wirkungsgrad führt.

Die vorliegende Erfindung ist in Anspruch 1 definiert.

Bevorzugte Ausführungsformen ergeben sich aus den abhängigen Patentansprüchen.

Die Erfindung soll nachstehend an einem Ausführungsbeispiel näher erläutert werden. In der zugehörigen Zeichnung zeigen:
- Fig. 1: eine schematische Darstellung eines Lasergainmoduls;
- Fig. 2: eine alternative Ausführung nach Fig. 1 mit einem Laserdiodenbarren;
- Fig. 3: das Lasergainmodul nach Fig. 1 in einen Laserresonator integriert;
- Fig. 4: das Lasergainmodul nach Fig. 2 in einen linearen Resonator integriert,
- Fig. 5: das Lasergainmodul nach Fig. 1 mit einem Dünnschichtpolarisator,
- Fig. 6: eine modifizierte Anordnung nach Fig. 5 mit zwei Verzögerungsplatten.

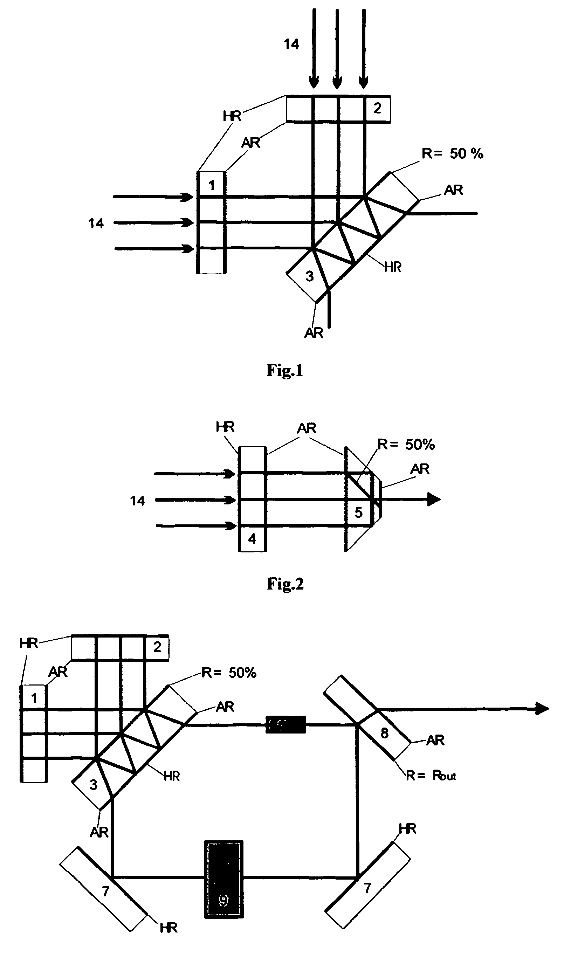

In Fig. 1 ist eine Ausführung dargestellt, die mit zwei Laserdiodenbarren gepumpt wird. Wichtig hierbei ist außerdem, dass das Licht des Laserdiodenbarrens in mehrere - in diesem Beispiel in drei - Pumpstrahlen 14 aufgeteilt wird (siehe auch DE 197 18 933.4). Es werden zwei aktive Medien 1 und 2 gepumpt. Das Strahlmanipulationselement 3 besitzt auf einer Seite eine teilreflektierende Beschichtung (in diesem Beispiel 50%) und auf der anderen Seite zwei getrennte Bereiche mit einer hochreflektierenden Beschichtung (HR) und einer Antireflex-Beschichtung (AR). Der Abstand der Strahlen, der dem Abstand der gepumpten Bereiche entsprechen muss, ist durch die Dicke und den Brechungsindex des benutzten Materials gegeben. Dementsprechend muss das Kopplungselement der benutzten Strahlformungsoptik für das Pumplicht angepaßt werden.

In Fig. 2 ist eine Ausführung dargestellt, die mit einem Laserdiodenbarren gepumpt wird. Wieder ist das System für drei Pumpstrahlen 14 ausgelegt. Es wird nur ein aktives Medium 4 benutzt (z.B. Nd:YAG). Das Kopplungselement 5 ist in der Form eines Prismas mit abgeflachter Spitze ausgeführt. Bei dieser Ausführung befindet sich der teildurchlässige Spiegel innerhalb des Kopplungselementes 5. Es gibt zwei Flächen mit einer AR Beschichtung. Auf eine HR Beschichtung kann in diesem Fall verzichtet werden, da innerhalb des Prismas eine Totalreflektion stattfindet. Wenn das Strahlmanipulationselement aus laseraktivem Material z.B. Nd:YAG oder Nd:YVO₄ gefertigt wird, läßt sich die Komplexität des Aufbaus noch einmal deutlich verringern.

In Fig. 3 ist das Lasergainmodul aus Fig. 1 innerhalb eines Laserresonators dargestellt. In diesem Fall ist der Resonator als Ringresonator mit einer optischen Diode 9, zwei Umlenkspiegeln 7, einem Auskoppelspiegel 8 und einer Frequenzverdopplungseinheit 10 aufgebaut.

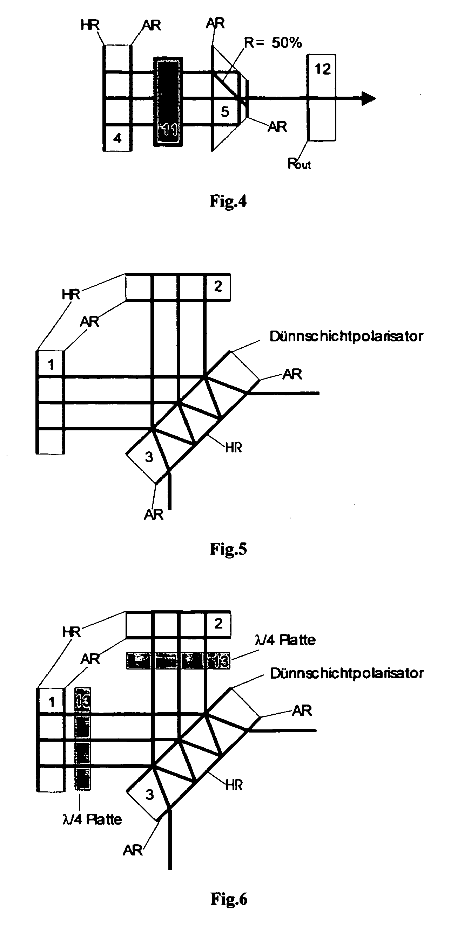

In Fig. 4 ist das Lasergainmodul aus Fig. 2 innerhalb eines linearen Resonators dargestellt. Neben dem Kopplungselement 5 und dem aktiven Medium 4 befindet sich ein Güteschalter 11- z.B. ein akustooptischer Modulator - im Resonator. Diese Art von Laser kann z.B. in Beschriftungslasern oder in extern frequenzverdoppelten Systemen eingesetzt werden. Die Benutzung eines Auskoppelspiegels 12 mit einer Auskoppelreflektivität Rₒᵤₜ wird hier wahrscheinlich nicht notwendig sein, da die effektive Reflektivität des Strahlmanipulationselementes hoch genug ist.

In Fig. 5 ist das Lasergainmodul aus Fig. 1 mit einem Dünnschichtpolarisator anstelle eines teilreflektierenden Spiegels dargestellt. Diese Anordnung führt dazu, dass nur die vom Polarisator nicht reflektierte Polarisation verstärkt wird. Die andere Polarisation wird innerhalb des Strahlmanipulationselements 3 reflektiert und nicht verstärkt. Die Strahlengänge, in denen eine Verstärkung stattfindet, sind wie bei der Version mit dem teilverspiegelten Strahlmanipulationselement, gekoppelt.

In Fig. 6 befinden sind zusätzlich zwei λ/4 Verzögerungsplatten 13 vor den aktiven Medien 1 und 2. Diese führen in Verbindung mit dem Dünnschichtpolarisator dazu, dass die vom Dünnschichtpolarisator durchgelassene Polarisation abwechselnd die drei Verstärkungsgebiete in den beiden aktiven Medien durchläuft.

Grundsätzlich lassen sich aus den Strahlmanipulationselementen 3 mit den aktiven Medien 1; 2 verschiedenste Resonatortypen realisieren. Eine weitere wichtige Eigenschaft der Aufbauten, bei denen die verschiedenen Strahlengänge gekoppelt sind, ist die gleichzeitige Existenz mehrerer Resonatorlängen. Hierdurch existieren innerhalb des Gesamtresonators stärkere Einschränkungen an die Resonanzbedingung. Die Zahl der longitudinalen Moden ist daher bei geeigneter Wahl der Längen stark verringert. Für resonatorintern frequenzverdoppelte Laser hat das eine wesentlich verbesserte Stabilität der Ausgangsleistung zur Folge.

## Patentansprüche

1. Lasergainmodul, welches mindestens ein laseraktives Medium (1, 2) umfasst, welches an mehreren Stellen gleichzeitig endgepumpt wird, so dass mehrere Strahlengänge im laseraktiven Medium (1, 2) entstehen, wobei die Strahlengänge koaxial zu den jeweils zugehörigen Pumpstrahlen verlaufen, **dadurch gekennzeichnet, dass** das Lasergainmodul mindestens ein Strahlmanipulations-element (3), welches als Strahlteilerwirkt, umfasst, durch welches die Strahlengänge derart miteinander verbunden werden, dass die gepumpten Stellen in laseraktiven Medium miteinander gekoppelt sind.

2. Lasergainmodul nach Anspruch 1, **dadurch gekennzeichnet, dass** alle oder einzelne Gruppen der Strahlengänge, in denen eine Verstärkung stattfindet, parallel verlaufen.

3. Lasergainmodul nach einem der Ansprüche 1 und 2, **dadurch gekennzeichnet, dass** mindestens eine der Grenzflächen mindestens eines Strahlmanipulationselements teilreflektierende Eigenschaften besitzt.

4. Lasergainmodul nach einem der Ansprüche 1 bis 3, **dadurch gekennzeichnet, dass** mindestens eine der Grenzflächen eine solche Wellenlängenabhängigkeit besitzt, dass in dem Lasergainmedium unterschiedliche Wellenlängen verstärkt werden können.

5. Lasergainmodul nach einem der Ansprüche 1 bis 4, **dadurch gekennzeichnet, dass** mindestens eine der Grenzflächen mindestens eines der Strahlmanipulationselemente polarisierende Eigenschaften besitzt.

6. Lasergainmodul nach Anspruch 5, **dadurch gekennzeichnet, dass** zusätzlich noch mindestens ein polarisationsbeeinflussendes Element in mindestens einem der Strahlengänge, in denen eine Verstärkung stattfindet, angeordnet ist.

7. Lasergainmodul nach Anspruch 6, **dadurch gekennzeichnet, dass** mindestens eines der sich zusätzlich in den Strahlengängen, in denen eine Verstärkung stattfindet, befindenden Elemente eine Verzögerungsplatte ist.

8. Lasergainmodul nach einem der Ansprüche 1 bis 7, **dadurch gekennzeichnet, dass** mindestens ein Strahlmanipulationselement mit Strahlteilereigenschaft mit mindestens einem aktiven Medium monolithisch verbunden ist.

9. Lasergainmodul nach einem der Ansprüche 1 bis 8, **dadurch gekennzeichnet, dass** das Strahlmanipulationselement mit Strahlteilereigenschaft gleichzeitig als aktives Medium dient.

10. Laserresonator, **dadurch gekennzeichnet, dass** in dem Laserresonator mindestens ein Lasergainmodul nach einem der Ansprüche 1 bis 9 angeordnet ist.

11. Laserresonator nach Anspruch 10, **dadurch gekennzeichnet, dass** die unterschiedlichen Resonatorlängen in den Verstärkerarmen zu einem longitudinalen Einmodenbetrieb führen.

12. Laserresonator nach Anspruch 10, **dadurch gekennzeichnet, dass** eine resonatorinteme Frequenzvervielfachung stattfindet.

13. Laserresonator nach Anspruch 10, **dadurch gekennzeichnet, dass** der Resonator passiv gütegeschaltet ist.

14. Laserresonator nach Anspruch 10, **dadurch gekennzeichnet, dass** der Resonator aktiv gütegeschaltet ist.

15. Laserresonator nach einem der Ansprüche 13 bis 14, **dadurch gekennzeichnet, dass** das Strahlmanipulationselement (3) auch die Funktion des Güteschalters übernimmt.

16. Laserresonator nach Anspruch 10, **dadurch gekennzeichnet, dass** der Laser simultan auf mehreren Wellenlängen betreibbar ist.

17. Laserresonator nach Anspruch 10, **dadurch gekennzeichnet, dass** eine oder mehrere der simultan erzeugten Wellenlängen resonatorintern frequenzvervielfacht werden.

18. Laserresonator nach Anspruch 10, **dadurch gekennzeichnet, dass** die verschiedenen Strecken im Resonator so angepaßt sind, dass der Laser zur Erzeugung ultrakurzer Pulse aktiv oder passiv modengekoppelt betreibbar ist.

## Claims

1. A laser gain module which comprises at least one laser active medium (1, 2), which is end pumped in several sites, so that several beam paths are created in the laser active medium (1, 2), whereby the beam paths run coaxially to the respective corresponding pump beams, **characterized in that** the laser gain module comprises at least one beam manipulation element (3) which acts as a beam splitter, via which the beam paths are connected with each other in such a manner that the pumped sites in the laser active medium are coupled with each other.

2. A laser gain module according to claim 1, **characterized in that** all or individual groups of beam paths in which an amplification occurs run in parallel.

3. A laser gain module according to either of claims 1 and 2, **characterized in that** at least one of the contact surfaces of at least one beam manipulation element shows partially reflective properties.

4. A laser gain module according to any one of claims 1 to 3, **characterized in that** at least one of the contact surfaces has a wavelength dependence of such a nature that in the laser gain medium, different wavelengths can be amplified.

5. A laser gain module according to any one of claims 1 to 4, **characterized in that** at least one of the contact surfaces of at least one of the beam manipulation elements has polarising properties.

6. A laser gain module according to claim 5, **characterized in that** in addition, at least one polarisation influencing element is arranged in at least one of the beam paths in which an amplification occurs.

7. A laser gain module according to claim 6, **characterized in that** at least one of the elements which is additionally located in the beam paths in which an amplification occurs is a delay plate.

8. A laser gain module according to any one of claims 1 to 7, **characterized in that** at least one beam manipulation element with a beam splitting property is connected monolithically with at least one active medium.

9. A laser gain module according to any one of claims 1 to 8, **characterized in that** the beam manipulation element with the beam splitting property simultaneously serves as an active medium.

10. A laser resonator, **characterized in that** in the laser resonator, at least one laser gain module is arranged in accordance with any one of claims 1 to 9.

11. A laser resonator according to claim 10, **characterized in that** the different resonator lengths in the amplification arms lead to a longitudinal single-mode operation.

12. A laser resonator according to claim 10, **characterized in that** a frequency multiplication occurs within the resonator.

13. A laser resonator according to claim 10, **characterized in that** the resonator is passively Q-switched.

14. A laser resonator according to claim 10, **characterized in that** the resonator is actively Q-switched.

15. A laser resonator according to either of claims 13 to 14, **characterized in that** the beam manipulation element (3) also adopts the function of the Q-switch.

16. A laser resonator according to claim 10, **characterized in that** the laser can be simultaneously operated on several wavelengths.

17. A laser resonator according to claim 10, **characterized in that** the frequencies of one or more of the simultaneously generated wavelengths are multiplied within the resonator.

18. A laser resonator according to claim 10, **characterized in that** the different routes in the resonator are adapted in such a manner that the laser can be operated actively or passive mode-coupled in order to generate ultra-short pulses.

## Revendications

1. Module de gain laser, comprenant au moins un milieu actif de laser (1, 2), lequel est pompé longitudinalement simultanément en plusieurs emplacements, de telle sorte que plusieurs chemins optiques sont générés dans le milieu actif de laser (1, 2), les chemins optiques ayant une direction coaxiale relativement aux faisceaux de pompage respectifs correspondants, **caractérisé en ce que** le module de gain laser comprend au moins un élément de manipulation de faisceau (3), lequel agit comme séparateur de faisceau, par lequel les chemins optiques sont reliés entre eux de telle sorte que les emplacements pompés sont couplés entre eux dans le milieu actif de laser.

2. Module de gain laser selon la revendication 1, **caractérisé en ce que** tous les groupes, ou des groupes isolés, des chemins optiques dans lesquels une amplification a lieu suivent une direction parallèle.

3. Module de gain laser selon les revendications 1 et 2, **caractérisé en ce qu'**au moins une des interfaces d'au moins un élément de manipulation de faisceau possède des propriétés de réflexion partielle.

4. Module de gain laser selon les revendications 1 à 3, **caractérisé en ce qu'**au moins une des interfaces possède une telle dépendance de la longueur d'onde que différentes longueurs d'onde peuvent être amplifiées dans le module de gain laser.

5. Module de gain laser selon les revendications 1 à 4, **caractérisé en ce qu'**au moins une des interfaces d'au moins un élément de manipulation de faisceau possède des propriétés de polarisation.

6. Module de gain laser selon la revendication 5, **caractérisé en ce qu'**en plus, au moins un élément influençant la polarisation est disposé dans au moins un des chemins optiques dans lesquels une amplification a lieu.

7. Module de gain laser selon la revendication 6, **caractérisé en ce qu'**au moins un des éléments se trouvant en plus dans les chemins optiques pour lesquels une amplification a lieu est une lame à retard.

8. Module de gain laser selon l'une des revendications 1 à 7, **caractérisé en ce qu'**au moins un élément de manipulation de faisceau avec propriété de séparateur de faisceau est relié monolithiquement avec au moins un milieu actif.

9. Module de gain laser selon l'une des revendications 1 à 8, **caractérisé en ce que** l'élément de manipulation de faisceau avec propriété de séparateur de faisceau sert en même temps de milieu actif.

10. Résonateur laser, **caractérisé en ce que**, dans le résonateur laser, au moins un module de gain laser selon l'une des revendications 1 à 9 est disposé.

11. Résonateur laser selon la revendication 10, **caractérisé en ce que** les différentes longueurs de résonateur dans les branches d'amplificateur conduisent à un fonctionnement monomode longitudinal.

12. Résonateur laser selon la revendication 10, **caractérisé en ce qu'**une multiplication de fréquences interne au résonateur a lieu.

13. Résonateur laser selon la revendication 10, **caractérisé en ce que** le résonateur est à déclenchement passif.

14. Résonateur laser selon la revendication 10, **caractérisé en ce que** le résonateur est à déclenchement actif.

15. Résonateur laser selon l'une des revendications 13 à 14, **caractérisé en ce que** l'élément de manipulation de faisceau (3) assume aussi la fonction du Q-Switch.

16. Résonateur laser selon la revendication 10, **caractérisé en ce que** le laser est opérable simultanément sur différentes longueurs d'onde.

17. Résonateur laser selon la revendication 10, **caractérisé en ce qu'**une ou plusieurs des longueurs d'onde générées simultanément subissent une multiplication de fréquences dans le résonateur.

18. Résonateur laser selon la revendication 10, **caractérisé en ce que** les différents chemins sont ajustés dans le résonateur de telle sorte que le laser est opérable en modes couplés, activement ou passivement, pour la génération d'impulsions ultracourtes.
